# EUROPÄISCHE PATENTSCHRIFT

(11) **EP 2 558 406 B1**
(45) Veröffentlichungstag und Bekanntmachung des Hinweises auf die Patenterteilung: **09.01.2019**
(21) Anmeldenummer: 11709422.7
(22) Anmeldetag: 22.03.2011
(51) Int. Cl.: B81C 1/00

(54) **MIKROELEKTRONISCHES BAUELEMENT**
MICROELECTRONIC COMPONENT
COMPOSANT MICROÉLECTRONIQUE

(30) Priorität: 13.04.2010 DE 102010003928
(43) Veröffentlichungstag der Anmeldung: 20.02.2013
(73) Patentinhaber: IHP GmbH-Innovations for High Performance Microelectronics / Leibniz-Institut für innovative Mikroelektronik, 15236 Frankfurt / Oder (DE)
(72) Erfinder: KAYNAK, Mehmet, 15230 Frankfurt (Oder) (DE); TILLACK, Bernd, 15234 Frankfurt (Oder) (DE); SCHOLZ, René, 06114 Halle (DE)
(74) Vertreter: Eisenführ Speiser
(86) Internationale Anmeldenummer: PCT/EP2011/054362
(87) Internationale Veröffentlichungsnummer: WO 2011/128188

(56) Entgegenhaltungen:
- US-A1- 2004 104 454
- US-A1- 2004 232 107
- US-A1- 2009 166 772

## Beschreibung

Die Erfindung betrifft ein mikroelektronisches Bauelement, ein Zwischenprodukt und ein Verfahren zur Herstellung eines mikroelektronischen Bauelements, wie beispielsweise eines integrierten MEMS-Bauelements, umfassend ein Substrat, das eine vorzugsweise monolithisch integrierte mikroelektronische Schaltung und einen Mehrebenen-Leitbahnschichtstapel auf einer Substratvorderseite enthält.

Die Erfindung wird nachfolgend ohne Beschränkung ihre allgemeine Anwendbarkeit unter Bezug auf ein MEMS-Bauelement beschrieben. MEMS ist eine im Stand der Technik geläufige Abkürzung für ein mikroelektromechanisches System. Eine MEMS-Schichtstruktur umfasst beispielsweise mikromechanische Strukturelemente, die im Mehrebenen-Leitbahnschichtstapel ausgebildet sind, wobei die mikromechanischen Strukturelemente der MEMS-Schichtstruktur mechanisch beweglich oder unbeweglich sein können.

Wie bekannt ist, kann die Anfertigung mikromechanischer Strukturen dadurch erfolgen, dass durch Strukturierung der verschiedenen, durch Isolationsschichten getrennten Metallebenen, die zur elektrischen Verbindung der auf der Oberfläche eines Siliziumsubstrates erzeugten mikroelektronischen Bauelemente wie z. B. Transistoren verwendet werden, gleichzeitig auch mikromechanische Strukturen erzeugt werden. Besonders vorteilhaft ist dabei, dass mikromechanische Aktuatoren und Sensoren direkt mit elektronischen Schaltungen als MEMS verbunden werden, was insbesondere bei hohen Frequenzen im GHz-Bereich vorteilhaft ist. Eine derartige Lösung ist beispielsweise in der WO 2009/003958 beschrieben. Ein MEMS nach dieser Bauart besitzt vielfältige Anwendungsmöglichkeiten z. B. als Schalter für hochfrequente Signale oder Sensoren.

US 2004/0104454 A1 beschreibt ein Halbleiterbauelement mit einem Halbleitersubstrat und einem dünnen Abschnitt des Halbleitersubstrats, der ein Loch zur Verbindung mit einem zu entfernenden Hauptteil des Substrats aufweist und der bei dem dort beschrieben Ätzprozess eine Ätzrate aufweist, die geringer ist als die Ätzrate des Hauptteils. US 2004/0232107 A1 beschreibt eine Herstellungsmethode für eine Mikrostruktur, bei der eine dünnwandige Struktur hergestellt wird, indem ein Substrat durch eine Maske mit einer nicht maskierenden Region geätzt wird. US 2009/0166772 A1 beschreibt ein Mikroelektromechnisches System, das über einen Mehrebenen-Leitbahnschichtstapel auf einer Substrat-Vorderseite eines Substrates verfügt.

Es hat sich als vorteilhaft erwiesen, dass die Freiätzung zur Herstellung der mechanischen Beweglichkeit der im Mehrebenen-Leitbahnschichtstapel eingebetteten mikromechanischen Strukturelemente von der Rückseite des Substrates durch eine lokale, bis zur Vorderseite durchgehende Öffnung im Silizium des Substrates (im Weiteren Ausnehmung genannt) erfolgt. Damit kann die Abdeckung und Passivierung der integrierten elektronischen Schaltung des MEMS-Bauelements auf der Substratvorderseite nach herkömmlichen Verfahren durchgeführt werden, so dass die empfindlichen mikromechanischen Teile der MEMS-Struktur auf der Vorderseite optimal geschützt und hermetisch versiegelt sind. Die hermetische Versiegelung der mikromechanischen Struktur auf der Rückseite des Substrates kann dann kostengünstig vor der Vereinzelung der Chips erfolgen, beispielsweise durch Waferbonden mittels einer planbaren Abdeckplatte aus SiO₂ oder Si.

Ein Problem bei der Herstellung dieser Art eines MEMS-Bauelements ist es, dass die verwendeten Masken für die ätztechnische Freilegung der mikromechanischen Struktur von der Rückseite her mit denjenigen Masken ausgerichtet sein müssen, die für die Herstellung der integrierten elektronischen Schaltung und der zunächst noch eingebetteten mikromechanischen Strukturelemente auf der Oberseite verwendet wurden. Zur Lösung dieses Problems ist die Verwendung einer Kamera denkbar, die gleichzeitig ein Bild von der Oberseite und der Unterseite des Substrates aufnimmt. Möglich ist auch die Verwendung einer Infrarot-Kamera. Allerdings sind diese Mittel entweder aufwändig oder mit einem zu großen Lagefehler (Versatz) behaftet, wenn man bedenkt, dass bei einer Dicke des Substrates von 300 bis 750 µm und Abmessungen der mikromechanischen Strukturelemente im µm-Bereich bereits ein geringer Versatz der verwendeten Masken ausreicht, um Fehlfunktionen zu bewirken. Hinzu kommt, dass die Tiefenätzung zur Herstellung der Ausnehmung im Substrat keine zur Oberfläche des Substrats senkrechten Wände erzeugt. Typischerweise entsteht eine konische Form der Ausnehmung, was bedingt, dass weitere Fertigungstoleranzen berücksichtigt werden müssen.

Aufgabe der Erfindung ist es, eine Lösung vorzuschlagen, bei der ein Versatz der für die Bearbeitung der Vorderseite und Rückseite verwendeten Maskensätze für die Herstellung des MEMS mit für die Fertigung beherrschbaren Toleranzen zugelassen wird und gleichzeitig größere Fertigungstoleranzen bei der tiefen Si-Ätzung zur Herstellung der Ausnehmung im Substrat zulässig sind.

Dieses technische Problem wird in unterschiedlichen Aspekten der Erfindung durch ein Verfahren nach Anspruch 1 gelöst. Ausführungsbeispiele dieser unterschiedlichen Aspekte der Erfindung sind in den abhängigen Ansprüchen definiert.

Gemäß der Erfindung wird ein Verfahren zur Herstellung eines mikroelektronischen Bauelements vorgeschlagen. Das Verfahren umfasst:
- Einbetten freizulegender Strukturelemente in einen Mehrebenen-Leitbahnschichtstapel im Zuge einer Herstellung des Mehrebenen-Leitbahnschichtstapels auf einer Substratvorderseite eines Substrats,
- Herstellen einer Ausnehmung, die von einer dem Mehrebenen-Leitbahnschichtstapel abgewandten Substratrückseite bis zur dem Mehrebenen-Leitbahnschichtstapel zugewandten Substratvorderseite reicht;
- Freilegen der Strukturelemente im Mehrebenen-Leitbahnschichtstapel durch Entfernen von Schichtabschnitten des Mehrebenen-Leitbahnschichtstapels von der Substratrückseite her durch die Ausnehmung hindurch.

Bei dem erfindungsgemäßen Verfahren wird das Herstellen einer Referenzmaske zur Definition einer lateralen Position oder einer lateralen Erstreckung des freizulegenden Strukturelements im Zuge der Herstellung des Mehrebenen-Leitbahnschichtstapels in einer im Vergleich mit dem freizulegenden Strukturelement dem Substrat näher gelegenen Schicht des Mehrebenen-Leitbahnschichtstapels angeordnet wird, und das Freilegen der Strukturelemente von der Substratrückseite her durch die Ausnehmung hindurch in von der Referenzmaske nicht abgedeckten Teilen einer Lateralerstreckung der Ausnehmung erfolgt.

Mit der erfindungsgemäßen Verfahrensführung kann bei der Herstellung der Ausnehmung ein größerer Fehler ihrer Ausrichtung bezogen auf die im Mehrebenen-Leitbahnschichtstapel eingebetteten und freizulegenden Strukturelemente zugelassen werden. Die relative Lage der Referenzmaske zu den freizulegenden Strukturelementen unterliegt aufgrund der gemeinsamen Fertigung der Referenzmaske und der freizulegenden Strukturelemente im Zuge der Herstellung des Mehrebenen-Leitbahnschichtstapels auf der Substratvorderseite geringen Toleranzen.

Nachfolgend werden Ausführungsbeispiele des erfindungsgemäßen Verfahrens erläutert. Die zusätzlichen Merkmale der jeweiligen Ausführungsformen können miteinander kombiniert werden, um weitere Ausführungsformen des Verfahrens zu bilden.

Das Herstellen der Ausnehmung kann also wie erläutert bei dem erfindungsgemäßen Verfahren mit einer größeren Fehlertoleranz durchgeführt werden. Es umfasst bevorzugt zunächst ein Herstellen einer Maske auf der Substratrückseite zur Definition einer lateralen Position und einer lateralen Erstreckung der Ausnehmung. Vorzugsweise wird die Ausnehmung im Substrat mit Hilfe eines Ätzprozesses, insbesondere eines Tiefätz-Prozesses nach dem Boschverfahren hergestellt. Andere dem Fachmann bekannte Verfahren sind jedoch ebenfalls anwendbar.

Das anschließende Entfernen der Schichtabschnitte des Mehrebenen-Leitbahnschichtstapels umfasst in bevorzugten Ausführungsbeispielen nasschemisches Ätzen.

Hierfür wird auf der Substratvorderseite in einer Weiterbildung des Verfahrens zusätzlich eine erste Ätzstopp-Schicht hergestellt, mit deren Erreichen das Herstellen der Ausnehmung im Substrat beendet wird und die vor dem Entfernen von Schichtabschnitten des Mehrebenen-Leitbahnschichtstapels teilweise oder vollständig entfernt wird. Mit der Verwendung einer ersten Ätzstopp-Schicht, die den Mehrebenen-Leitbahnschichtstapel vor Beeinträchtigung durch den Prozess zur Herstellung der Ausnehmung schützt, wird das erfindungsgemäße Konzept um eine zusätzliche Funktionsschicht erweitert.

Als Referenzmaske mit mindestens einer Öffnung zur Definition der lateralen Position oder der lateralen Erstreckung der freizulegenden, in bevorzugten Ausführungsbeispielen mikromechanischen Strukturelemente wird beispielsweise eine als Lochblende ausgeführte Maske verwendet. Diese wird in einer Ausführungsform neben Leiterzügen und mikromechanischen Strukturelementen bei der Herstellung des Mehrebenen-Leiterbahnstapels oder bei der Herstellung einer PolySi-Ebene mit erzeugt und eingebettet und nach Herstellung der Ausnehmung von der Rückseite des Substrats her freigelegt.

Die anschließende Freilegung der Strukturelemente erfolgt dann durch die Lochblende in der eingebetteten Referenzmaske, deren relative Lage zu den mechanischen Bauelementen durch ihre gemeinsame Fertigung auf der Vorderseite geringen Toleranzen unterliegt.

Das Freilegen erfolgt beispielsweise über einen selektiven Isolator-Ätzprozess. In einer weiterführenden Prozess-Variante wird die Referenzmaske als eine zweite Ätzstopp-Schicht verwendet. Auf diese Weise kann auch das nasschemische Ätzen lateral sehr genau kontrolliert werden und können Ätzfehler, die aufgrund eines Versatzes oder einer zu großen Erstreckung der Ausnehmung im Substrat beim nasschemischen Ätzen entstehen könnten, vermieden werden.

Bei einem Ausführungsbeispiel wird die Referenzmaske in einer Schicht des Mehrebenen-Leitbahnschichtstapels gebildet, die auch für Verbindungsleitungen zwischen verschiedenen Schaltungsteilen benutzt wird. Dieses Vorgehen hält den Verfahrensaufwand gering.

In derzeit besonders interessanten Anwendungsfällen des erfindungsgemäßen Verfahrens umfasst das Einbetten eines freizulegenden Strukturelements in den Mehrebenen-Leitbahnschichtstapel im Zuge des Herstellens des Mehrebenen-Leitbahnschichtstapels das Herstellen einer MEMS-Schichtstruktur mit mikromechanischen Strukturelementen. Damit gelingt es, MEMS-Bauelemente mit einer deutlich verbesserten Ausbeute, d. h. mit deutlich geringerem Ausschuss zu produzieren.

Ein hier nicht beanspruchter Aspekt betrifft ein mikroelektronisches Bauelement mit
- einem Substrat, das eine Substratvorderseite und eine zur Substratvorderseite entgegengesetzt orientierte Substratrückseite aufweist;
- einem Mehrebenen-Leitbahnschichtstapel auf der Substratvorderseite;
- einer Ausnehmung im Substrat, die sich von der Substratrückseite her bis in den Mehrebenen-Leitbahnschichtstapel erstreckt;
- freigelegten Strukturelementen in mindestens eine Ebene eines Mehrebenen-Leitbahnschichtstapels innerhalb einer lateralen Erstreckung der Ausnehmung; und
- einer Referenzmaske auf der Substratvorderseite zwischen dem Substrat und dem Mehrebenen-Leitbahnschichtstapel oder in einer im Vergleich mit dem freigelegten Strukturelement dem Substrat näher gelegenen Schicht des Mehrebenen-Leitbahnschichtstapels, zur Definition einer lateralen Position oder einer lateralen Erstreckung der Strukturelemente.

Das mikroelektronische Bauelement teilt die im Zusammenhang mit dem Verfahren des ersten Aspekts der Erfindung beschriebenen Vorteile. Die Durchführung des erfindungsgemäßen Verfahrens manifestiert sich in der Struktur des erfindungsgemäßen mikroelektronischen Bauelements darin, dass eine Referenzmaske vorhanden ist, die im Produktionsprozess zur Definition einer lateralen Position oder einer lateralen Erstreckung der in bevorzugten Ausführungsformen mikromechanischen Strukturelemente zwischen dem Substrat und dem Mehrebenen-Leitbahnschichtstapel oder in einer im Vergleich mit den freigelegten Strukturelementen dem Substrat näher gelegenen Schicht des Mehrebenen-Leitbahnschichtstapels dient.

Einen weiteren hier nicht beanspruchten Aspekt bildet ein Zwischenprodukt für die Herstellung eines mikroelektronischen Bauelements, mit
- einem Substrat, das eine Substratvorderseite und eine zur Substratvorderseite entgegengesetzt orientierte Substratrückseite aufweist;
- einem Mehrebenen-Leitbahnschichtstapel auf der Substratvorderseite;
- freizulegenden Strukturelementen in mindestens einer Ebene eines Mehrebenen-Leitbahnschichtstapels; und
- einer Referenzmaske auf der Substratvorderseite zwischen dem Substrat und dem Mehrebenen-Leitbahnschichtstapel oder in einer im Vergleich mit dem freizulegenden Strukturelement dem Substrat näher gelegenen Schicht des Mehrebenen-Leitbahnstapels zur Definition einer lateralen Position oder einer lateralen Erstreckung des Strukturelements im Rahmen eines von der Substratrückseite her durchzuführenden Ätz-Prozesses zur Freilegung des Strukturelements.

Das Zwischenprodukt unterscheidet sich vom mikroelektronischen Bauelement dadurch, dass das Substrat noch keine Ausnehmung aufweist. Das Zwischenprodukt wird typischerweise in einem Front-End-Of-Line-Prozess hergestellt und für die weitere Prozessierung zur Herstellung eines mikroelektronischen Bauelements auf dem Markt angeboten.

Nachfolgend werden Ausführungsbeispiele des mikroelektronischen Bauelements und des Zwischenprodukts gemeinsam beschrieben. Die zusätzlichen Merkmale der nachfolgend beschriebenen Ausführungsbeispiele stellen also sowohl für das mikroelektronische Bauelement als auch für das Zwischenprodukt vorteilhafte Weiterbildungen dar.

Wie oben bereits erläutert bilden bevorzugte Ausführungsformen des mikroelektronischen Bauelements MEMS-Bauelemente.

Bevorzugt ist die Referenzmaske in eine dielektrische Schicht des Mehrebenen-Leitbahnschichtstapels eingebettet. Sie kann aber alternativ auch in eine Schicht des Mehrebenen-Leitbahnschichtstapels eingebettet sein, die eine metallische Leitbahn enthält. Die Referenzmaske ist in weiteren Ausführungsbeispielen aus monokristallinen oder polykristallinen Silizium gefertigt.

Als Substrat eignet sich insbesondere ein Halbleitersubtrat, ein Isolatorsubstrat oder ein Metallsubstrat. Für die Anwendbarkeit der vorhandenen industriellen Produktionstechnologien ist die in einem Ausführungsbeispiel vorgesehene Verwendung eines Siliziumsubstrats von großer Bedeutung.

In einem bereits oben erläuterten bevorzugten Ausführungsbeispiel ist das freigelegte beziehungsweise freizulegende Strukturelement ein Teil eines mikromechanischen Bauelements (MEMS).

Weitere Ausführungsbeispiele der Erfindung werden nachfolgend anhand der Figuren erläutert. Es zeigen:
- Fig. 1: ein MEMS-Bauelement nach Stand der Technik;
- Fig. 2: eine Darstellung eines MEMS-Bauelements nach dem Stand der Technik zur Erläuterung von Fehlern in der Ausbildung von Strukturelementen, die beim Stand der Technik durch einen Maskenversatz erzeugt werden;
- Fig. 3: ein mikroelektronisches Bauelement hergestellt gemäß einem ersten Ausführungsbeispiel der Erfindung; und
- Fig. 4: ein mikroelektronisches Bauelement hergestellt gemäß einem zweiten Ausführungsbeispiel der Erfindung

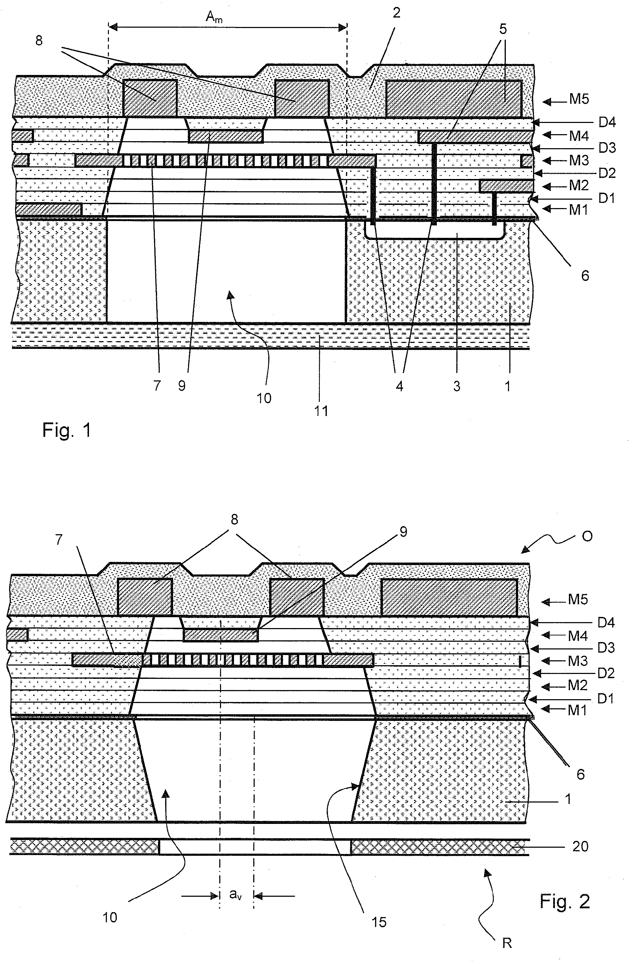

In Fig. 1 ist als Beispiel eines für die Anwendung der Erfindung geeigneten, als solches jedoch bekannten MEMS-Bauelements nach dem Stand der Technik ein als MEMS gestalteter RF-Schalter in einer schematischen Querschnittansicht dargestellt. Die Anwendbarkeit der Erfindung beschränkt sich selbstverständlich nicht auf einen solchen RF-Schalter, sondern erstreckt sich insbesondere auf eine Vielzahl von MEMS wie zum Beispiel Drucksensoren, Beschleunigungssensoren, Kippspiegel oder unbewegliche Sensorelemente. Sie ist auch für andere Bauelemente geeignet, bei denen Strukturen wie zum Beispiel mikrofluidische Kanäle zur Kühlung der mikroelektronischen Schaltung freizulegen sind, die auf der Substratvorderseite angeordnet sind.

Auf einem Siliziumsubstrat 1 sind mehrere, durch Dielektrika D1 bis D4 voneinander isolierte Metallisierungsebenen M1 bis M5 aufgebracht, die, entsprechend strukturiert, Leiterbahnen 5, 8 für die elektrische Verbindung der in die Oberfläche des Siliziumsubstrats eingearbeiteten Bauelemente 3 zugleich aber freigelegte mikromechanische Funktionselemente beispielsweise eine Membran 7 enthalten. Die Leiterbahnen verschiedener Metallisierungsebenen sind durch Vias 4 miteinander elektrisch verbunden. Von der Substratrückseite her freigelegte Leiterbahnen 8 bilden zusammen mit der Membran 7 einen elektrostatischen Antrieb, der beim Anlegen einer Spannung dazu führt, dass sich die Membran 7 hin zu einem ebenfalls freigelegten Elektrodensockel 9 bewegt und einen Schaltvorgang auslöst. Das Bauelement ist auf der Substratrückseite mit einer Abdeckplatte 11 für eine Ausnehmung 10 im Substrat 1 versehen.

Fig. 2 verdeutlicht anhand einer Querschnittansicht eines gleichartigen Bauelements das im Stand der Technik ungelöste Problem, das entsteht, wenn eine für die Einbringung der 10 Ausnehmung 10 ins Siliziumsubstrat 1 verwendete Maske 20 nicht exakt zu den im Mehrebenen-Leiterbahnstapel eingebetteten Strukturelementen 7, 8, 9 bzw. zu den Masken, die für die Herstellung der Strukturelemente verwendet wurden, ausgerichtet wurde. Ein dadurch entstehender Versatz a_{V} führt dazu, dass die Freilegung der mikromechanischen Strukturelemente mit Fehlern behaftet ist, die letztlich zur Funktionsuntüchtigkeit des MEMS führen können. Im vorliegenden Fall ist die Membran 7 nicht vollständig freigelegt.

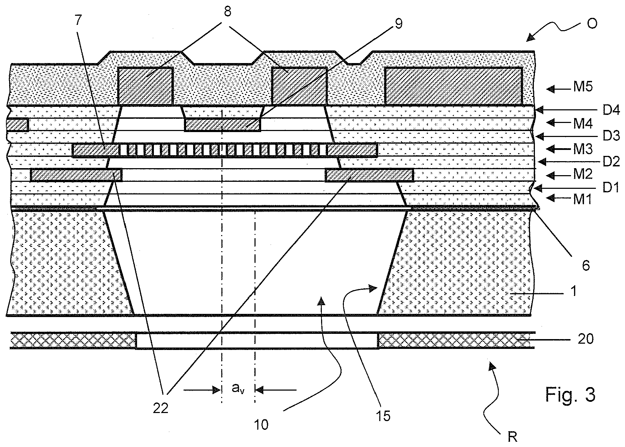

In Fig. 3 wird ein Beispiel eines erfindungsgemäß hergestellten mikroelektronischen Bauelements in Form eines MEMS-Bauelements gezeigt, bei dem die in Fig. 2 sichtbaren Probleme mit Hilfe einer Referenzmaske 22 gelöst sind. Die Struktur des MEMS-Bauelements gleicht ansonsten der Einfachheit der Darstellung halber der bereits in Fig. 1 und 2 gezeigten.

Die Herstellung des Bauelements der Fig. 3 mit freizulegenden Strukturelementen in Form einer von den mikromechanischen Funktionselementen 7 bis 9 gebildeten MEMS-Struktur erfolgt in der Art, dass zunächst während der Prozessschritte des so genannten Front-End of Line die Fertigung von elektronischen Schaltungselementen wie Transistoren etc. direkt auf der Oberfläche einer Vorderseite O der als Substrat fungierenden Siliziumscheibe 1 durchgeführt wird. In dem sich anschließenden Back-End of Line werden die elektronischen Schaltungselemente beim Herstellen eines Mehrebenen-Leitbahnschichtstapels auf der Substratvorderseite O durch Strukturierung von Metallisierungsebenen M1 bis M5 elektrisch miteinander verbunden, und werden zusätzlich die mikromechanischen Funktionselemente 7 bis 9 mit eingebracht.

Im Laufe der Herstellung des Mehrebenen-Leitbahnschichtstapels wird auch die Referenzmaske 22 eingebracht. Diese Referenzmaske 22 ist im vorliegenden Beispiel Teil der strukturierten Metallisierungsebene M2, kann aber auch Teil einer anderen Ebene im Back-end sein. Alternativ ist es möglich, die Referenzmaske bereits im Front-end of Line einzubringen, z. B. in einer PolySi-Ebene.

Nach Fertigstellung der Prozessschritte, die die Oberseite des MEMS betreffen, wird zur Freilegung der mikromechanischen Strukturelemente 7, 8, 9 durch einen Silizium-Tiefätz-Prozess eine Ausnehmung 10 durch die Maske 20 in das Substrat 1 eingebracht. Eine Silizium-Nitrid-Schicht 6 dient als Ätzstopp für den Tiefätz-Prozess. Die Abmessungen der Ausnehmung 10 sind dabei größer als die Abmessungen der mikromechanischen Strukturelemente 7, 8, 9 gewählt, um sicher zu stellen, dass sich diese Strukturelemente auch bei einem toleranzbedingten Versatz über der Ausnehmung befinden. Typischerweise erweitert sich die Ausnehmung in lateralen Richtungen während des Tiefätz-Prozesses, was durch schräg verlaufende Seitenwände 15 der Ausnehmung 10 veranschaulicht ist.

Die Freilegung der mikromechanischen Funktionselemente 7 bis 9 erfolgt nach Herstellung der Ausnehmung 10 von der Substratrückseite R her. Es wird zunächst die Ätzstoppschicht 6 im Bereich der Ausnehmung 10 geöffnet. Das eigentliche Freilegen der mikromechanischen Funktionselemente durch ein Nassätzverfahren führt zunächst bis zur Referenzmaske 22 und setzt sich durch die dargestellte Öffnung in der Referenzmaske 22 durch die folgenden Leitbahn-Ebenen M3 bis M5 und Isolator-Ebenen D2 bis D4 fort. Zum Freilegen des Raums zwischen Elektrodensockel 9 und Membran 7 ist diese perforiert.

In diesem Nassätz-Prozess definiert die Referenzmaske 22 die laterale Position und die laterale Ausdehnung der freigelegten Schichtabschnitte oberhalb der Referenzmaske 22 und verhindert somit Fehler, wie sie in Fig. 2 dargestellt sind. Da die Öffnung in der Referenzmaske 22 zusammen mit den mikromechanischen Funktionselementen von der Oberseite des Substrates hergestellt wurde, ist die Freilegung der mikromechanischen Funktionselemente an der Referenzmaske 22 und nicht an der Maske 20 ausgerichtet, die auf der Substratrückseite R verwendet wird. Damit wird die MEMS-Struktur 7,8,9 mit der deutlich besseren Toleranz der Referenzebene 22 freigelegt. Das Freilegen ist weitgehend unempfindlich gegenüber einer eventuell fehlerhaften Positionierung der Maske 20.

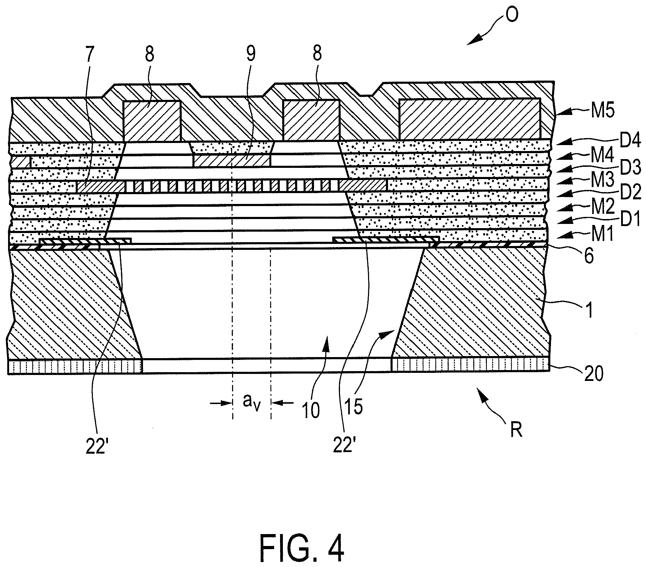

Fig. 4 zeigt eine Variante des Ausführungsbeispiels der Fig. 3. Das mikroelektronische Bauelement der Fig. 4 unterscheidet sich von dem der Fig. 3 lediglich darin, dass eine andere Referenzmaske 22' verwendet wird. Die Referenzmaske 22' ist zwischen dem Substrat und dem Mehrebenen-Leitbahnschichtstapel in einer PolySi-Ebene angeordnet. Die Referenzmaske 22' wird also im Unterschied zum Beispiel der Fig. 3 im Rahmen des Herstellungsprozesses des mikroelektronischen Bauelements bereits im Front-end of Line eingebracht. Die Referenzmaske 22' wird dabei ebenfalls aus Poly-Silizium gefertigt.

Grundsätzlich sind die Varianten der Fig. 3 und Fig. 4 gleichwertig verwendbar. Die Variante der Fig. 4 ist beispielsweise jedoch dann besser geeignet, wenn der Mehrebenen-Leitbahnschichtstapel eine geringe Anzahl von Schichtebenen aufweist oder sich über viele Schichtebenen erstreckende freizulegende mikromechanischen Funktionselemente enthält, die im Mehrebenen-Leitbahnschichtstapel keinen Platz für die unterhalb anzuordnende Referenzmaske lassen.

Nur der besseren Verständlichkeit halber zeigt Fig. 4 im Vergleich mit Fig. 3 im Wesentlichen dasselbe Bauelement. Die Variante der Fig. 4 mit einer Referenzmaske zwischen dem Substrat und dem Mehrebenen-Leitbahnschichtstapel ist selbstverständlich auch bei anderen mikroelektronischen Bauelementen anwendbar, in denen eine beliebige, im Mehrebenen-Leitbahnschichtstapel eingebettete Struktur freizulegen ist.

## Patentansprüche

1. Verfahren zur Herstellung eines mikroelektronischen Bauelements, umfassend
- Einbetten freizulegender Strukturelemente (7, 8, 9) in einen Mehrebenen-Leitbahnschichtstapel im Zuge einer Herstellung des Mehrebenen-Leitbahnschichtstapels auf einer Substratvorderseite eines Substrats (1),
- Herstellen einer Ausnehmung, die von einer dem Mehrebenen-Leitbahnschichtstapel abgewandten Substratrückseite (R) bis zur dem Mehrebenen-Leitbahnschichtstapel zugewandten Substratvorderseite (V) reicht;
- Freilegen der Strukturelemente (7, 8, 9) im Mehrebenen-Leitbahnschichtstapel durch Entfernen von Schichtabschnitten des Mehrebenen-Leitbahnschichtstapels von der Substratrückseite her durch die Ausnehmung hindurch, **gekennzeichnet durch**
- Herstellen einer Referenzmaske (22) zur Definition einer lateralen Position oder einer lateralen Erstreckung der freizulegenden Strukturelemente (7, 8, 9) im Zuge der Herstellung des Mehrebenen-Leitbahnschichtstapels, wobei
- die Referenzmaske (22) in einer im Vergleich mit den freizulegenden Strukturelemente (7, 8, 9) dem Substrat (1) näher gelegenen Schicht des Mehrebenen-Leitbahnschichtstapels angeordnet wird, und
- das Freilegen der Strukturelemente (7, 8, 9) von der Substratrückseite her durch die Ausnehmung hindurch in von der Referenzmaske (22) nicht abgedeckten Teilen einer Lateralerstreckung der Ausnehmung erfolgt.

2. Verfahren nach Anspruch 1, bei dem das Herstellen der Ausnehmung ein Herstellen einer Maske (20) auf der Substratrückseite zur Definition einer lateralen Position und einer lateralen Erstreckung der Ausnehmung umfasst.

3. Verfahren nach einem der vorstehenden Ansprüche, bei dem das Herstellen der Ausnehmung (10) im Substrat (1) das Durchführen eines Tiefätz-Prozesses nach dem Boschverfahren umfasst.

4. Verfahren nach einem der vorstehenden Ansprüche, bei dem das Entfernen der Schichtabschnitte (D2, D3) des Mehrebenen-Leitbahnschichtstapels (MLS) nasschemisches Ätzen umfasst.

5. Verfahren nach Anspruch 4, bei dem auf der Substratvorderseite zusätzlich eine erste Ätzstopp-Schicht hergestellt wird, mit deren Erreichen das Herstellen der Ausnehmung im Substrat beendet wird und die vor dem Entfernen von Schichtabschnitten des Mehrebenen-Leitbahnschichtstapels teilweise oder vollständig entfernt wird.

6. Verfahren nach Anspruch 4, bei dem die Referenzmaske eine zweite Ätzstopp-Schicht bildet und mindestens eine Öffnung zur Definition der lateralen Position oder der lateralen Erstreckung der freizulegenden Strukturelemente (7, 8, 9) aufweist.

7. Verfahren nach einem der vorstehenden Ansprüche, bei dem die Referenzmaske in einer Schichtebene des Mehrebenen-Leitbahnschichtstapels ausgebildet wird, die auch für Verbindungsleitungen zwischen verschiedenen Schaltungsteilen genutzt wird.

8. Verfahren nach einem der vorstehenden Ansprüche, bei dem das Einbetten der freizulegenden Strukturelemente (7, 8, 9) in den Mehrebenen-Leitbahnschichtstapel im Zuge des Herstellens des Mehrebenen-Leitbahnschichtstapels (MLS) das Herstellen einer MEMS-Schichtstruktur (MEM) mit mikromechanischen Strukturelementen (7, 9) umfasst.

## Claims

1. A method for producing a microelectronic component, comprising the steps:
- embedding structure elements (7, 8, 9) that are to be exposed in a multi-level conductive path layer stack on a substrate front side of a substrate (1) during producing the multi-level conductive path layer stack;
- producing a recess that extends from a substrate backside (R) oriented away from the multi-level conductive path layer stack to the substrate front side (V) oriented towards the multi-level conductive path layer stack;
- exposing the structure elements (7, 8, 9) in the multi-level conductive path layer stack by removing layer sections of the multi-level conductive path layer stack from the substrate backside through the recess; **characterized in that**
- producing a reference mask (22) for defining a lateral position or a lateral extension of the structure elements (7, 8, 9) to be exposed during producing the multi-level conductive path layer stack,
- wherein the reference mask (22) is r arranged in a layer of the multi-level conductive path layer stack which layer is more proximal to the substrate (1) compared to the structure elements (7, 8, 9) to be exposed, and
- exposing the structure elements (7, 8, 9) is performed from the substrate backside through the recess in portions of a lateral extension of the recess not covered by the reference mask

2. The method according to claim 1, wherein producing the recess includes producing a mask (20) on the substrate back side for defining a lateral position and a lateral extension of the recess.

3. The method according to one of the preceding claims, wherein producing the recess (10) in the substrate (1) includes performing a deep etching process according to the Bosch method.

4. The method according to one of the preceding claims, wherein removing the layer sections (D2, D3) of the multi-level conductive path layer stack (MLS) includes wet chemical etching.

5. The method according to claim 4, wherein a first etch stop layer is additionally produced on the substrate front side, wherein producing the recess in the substrate is terminated when the etch stop layer is reached and wherein the etch stop layer is partially or completely removed before removing layer sections of the multi-level conductive path layer stack.

6. The method according to claim 4, wherein the reference mask forms a second etch stop layer and includes at least one opening for defining the lateral position or the lateral extension of the structure elements (7, 8, 9) to be exposed.

7. The method according to one of the preceding claims, wherein the reference mask is formed in a layer level of the multi-level conductive path layer stack, wherein the layer level is also used for connecting conductors between various circuit elements.

8. The method according to one of the preceding claims, wherein embedding structure elements (7, 8, 9) in the multi-level conductive path layer stack, wherein the structure element is to be exposed, includes producing a MEMS layer structure (MEM) with micro mechanical structure elements (7, 9) during producing the multi-level conductive path layer stack (MLS).

## Revendications

1. Procédé de fabrication d'un composant micro-électronique comprenant
- l'incorporation d'éléments structurels à exposer (7, 8, 9) dans une pile de couches à pistes conductrices sur plusieurs niveaux au cours d'une fabrication de la pile de couches à pistes conductrices sur plusieurs niveaux sur la face avant d'un substrat (1),
- la réalisation d'un évidement, qui va d'une face arrière du substrat (R) opposée à la pile de couches à pistes conductrices sur plusieurs niveaux jusqu'à la face avant du substrat (V) orientée vers la pile de couches à pistes conductrices sur plusieurs niveaux ;
- l'exposition des éléments structurels (7, 89) dans la pile de couches à pistes conductrices sur plusieurs niveaux par élimination de portions de couches de la pile de couches à pistes conductrices sur plusieurs niveaux à partir de la face arrière du substrat à travers l'évidement,
**caractérisé par**
- la réalisation d'un masque de référence (22) pour la définition d'une position latérale ou une extension latérale des éléments structurels à exposer (7, 8, 9) au cours de la fabrication de la pile de couches à pistes conductrices sur plusieurs niveaux,
- le masque de référence (22) étant disposé dans une couche de la pile de couches à pistes conductrices sur plusieurs niveaux plus proche du substrat (1) que les éléments structurels à exposer (7, 8, 9) et
- l'exposition des éléments structurels (7, 8, 9) ayant lieu à partir de la face arrière du substrat à travers l'évidement dans des parties du masque de référence (22) non recouvertes d'une extension latérale de l'évidement.

2. Procédé selon la revendication 1, dans lequel la réalisation de l'évidement comprend la réalisation d'un masque (20) sur la face arrière du substrat pour la définition d'une position latérale et d'une extension latérale de l'évidement.

3. Procédé selon l'une des revendications précédentes, dans lequel la réalisation de l'évidement (10) dans le substrat (1) comprend l'exécution d'un processus de gravure profonde selon le procédé Bosch.

4. Procédé selon l'une des revendications précédentes, dans lequel l'élimination des portions de couches (D, D3) de la pile de couches à pistes conductrices sur plusieurs niveaux (MLS) comprend une gravure chimique par voie humide.

5. Procédé selon la revendication 4, dans lequel, sur la face avant du substrat, est en outre réalisée une couche d'arrêt de gravure au niveau de laquelle la réalisation de l'évidement dans le substrat est terminée et qui est éliminée partiellement ou complètement avant l'élimination des portions de couches de la pile de couches à pistes conductrices sur plusieurs niveaux.

6. Procédé selon la revendication 4, dans lequel le masque de référence forme une couche d'arrêt de gravure et au moins une ouverture pour la définition de la position latérale ou de l'extension latérale des éléments structurels à exposer (7, 8, 9).

7. Procédé selon l'une des revendications précédentes, dans lequel le masque de référence est réalisé dans un niveau de couche de la pile de couches à pistes conductrices sur plusieurs niveaux, qui est utilisé également pour des lignes de liaison entre différentes parties de circuits.

8. Procédé selon l'une des revendications précédentes, dans lequel l'incorporation des éléments structurels à exposer (7, 8, 9) dans la pile de couches à pistes conductrices sur plusieurs niveaux comprend, au cours de la fabrication de la pile de couches à pistes conductrices sur plusieurs niveaux (MLS), la fabrication d'une structure en couches MEMS (MEM) avec des éléments structurels micro-mécaniques (7, 9).
